# EUROPEAN PATENT SPECIFICATION

(11) **EP 0 436 746 B1**
(45) Date of publication and mention of the grant of the patent: **12.06.1996**
(21) Application number: 89312452.9
(22) Date of filing: 30.11.1989
(51) Int. Cl.: C08G 18/10, C08G 18/58, C08G 59/40, C09J 175/06

(54) **Process of manufacture for high performance epoxy based laminating adhesives**
Verfahren zur Herstellung von Verbundklebstoffen auf Basis von Epoxydharz
Procedure de preparation pour produits stratifiés à partir d'époxide

(43) Date of publication of application: 17.07.1991
(73) Proprietor: COURTAULDS PERFORMANCE FILMS, Chandler Arizona 85226-9498 (US)
(72) Inventor: Gardeski, Thomas F., Arizona (US)
(74) Representative: Taylor, Phillip Kenneth

(56) References cited:
- EP-A- 0 126 297
- CH-A- 391 160
- FR-A- 2 095 913

## Description

During the past quarter century, the growth of the electronic circuits industry at an unrivaled pace has resulted in the development of higher performance materials of construction. However, with the development of higher performance materials of construction has not resulted in the development of corresponding high performance adhesive materials and systems to bond the materials of construction together, especially in severe environmental conditions found in under-the-hood automotive and military applications. Adhesive materials and systems that are currently available meet some of the requirements for such properties as peel strength, chemical resistance, moisture resistance, high temperature stability, dimensional stability especially in the Z-axis direction and ease of processing, but typically fail to meet one or more of the requirements for one or more of the properties.

A need has therefore been felt for an adhesive material that meets all the requisite property requirements for severe environmental conditions while retaining the ease of application.

It is an object of the present invention to provide a process for an improved adhesive material.

It is a feature of the present invention to provide an improved material suitable for use with electronic construction materials.

It is yet another feature of the present invention to provide an adhesive material that requires a two stage reaction process for bonding.

It is yet a further feature of the present invention to combine an isocyanate component, a polyester component and one or more epoxy components using a two stage reaction to provide a high performance adhesive material.

The foregoing and other features are accomplished, according to the present invention, by combining at least one epoxy component chosen from the flexible bis-epi and the hard novolac epoxy families and at least one high molecular weight polyester component along with an isocyanate cure mechanism. The isocyanate curing agent and the polyester component interact in a first reaction stage. The isocyanate/polyester compound resulting from the first reaction stage and the epoxy components are combined. The resulting combination can be applied to a surface of a laminate layer or another first surface. A second surface can be placed in contact with the first surface and a second reaction stage permitted to take place, forming the high performance bond.

These and other features will be understood by the reading of the following description.

According to the process claimed in the present invention at least one and preferably two epoxy components selected from the flexible bis-epi and hard novolac families, such as Celanese Epi-Rez-5132 and Dow D.E.N. 438 respectively; at least one high molecular weight polyester component such as DuPont's 49002 or DeSoto's 301 resin systems; and an isocyanate cure mechanism such as Upjohn's PAPI-135 or Mobay's Mondur MRS are reacted in a specific sequence.

The cure sequence of the present invention consists of first reacting the isocyanate component with the hydroxyl groups which terminate the polyester component as shown in the following reaction sequence known in the related art. 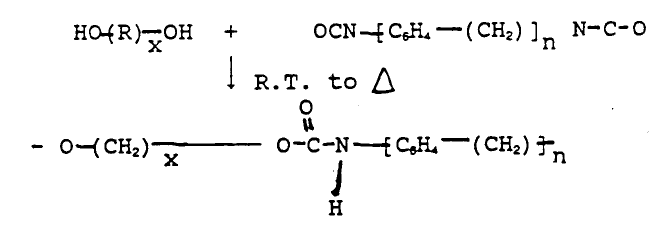
where (R)ₓ represents a high molecular weight polyester repeating unit with alcohol type hydroxyl end group functionality. This reaction takes place at room temperature slowly and more rapidly with heating of the composition to 250°F. The secondary reaction, involves reaction of the 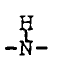
group in the formed urethane linkage with the epoxide 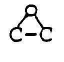
groups of the epoxy components as follows: 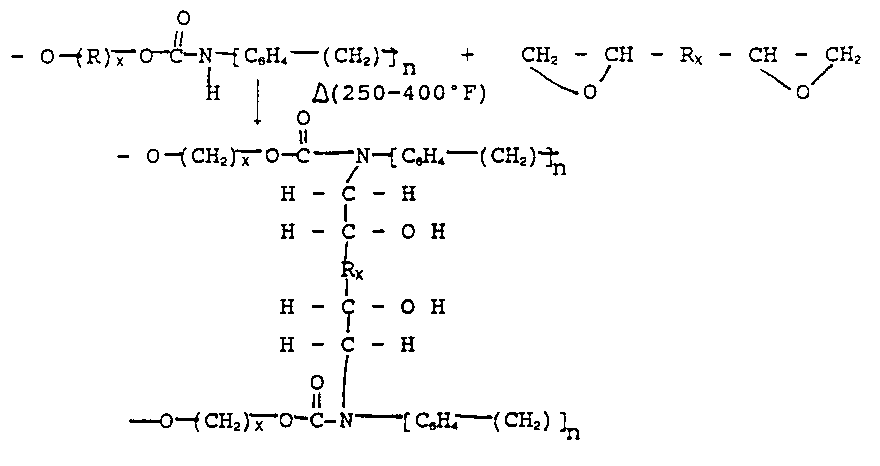
where Rₓ in this formula represents the bis-epi and/or novolac epoxy structures as shown below:

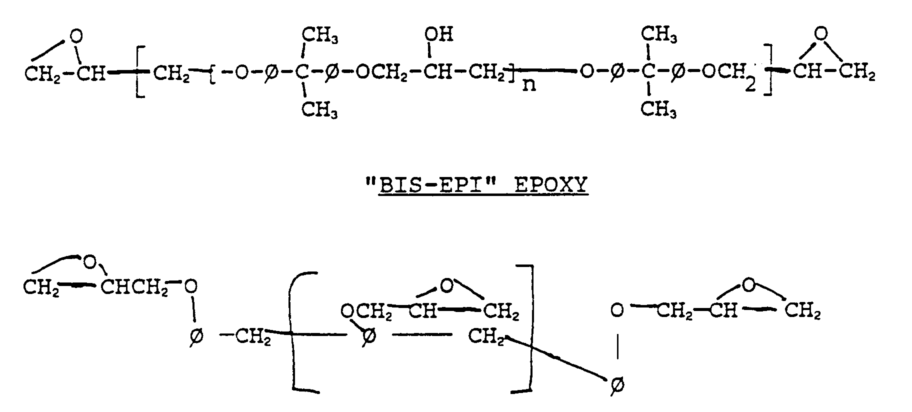

### "NOVOLAC" EPOXY

### Example of the Process

The components of the adhesive material processed according to the present invention, in one embodiment, are: a polyester resin having a solids content of 17-20% composed of DuPont 49002 base in a solvent mixture of 90% methylene chloride to 10% cyclohexanone by weight; an epoxy novolac at 85% solids composed of Dow DEN 438-EK85 in methylethylketone; and a bis-epi epoxy composed of Celanese Epi-Rez 5132 at 100% solids; and a curative component of a polyfunctional isocyanate sold by Mobay under the trade name Mondur MRS. The components can be combined according to the following two procedures:
Procedure 1) The adhesive coating composition is made by adding 80% by solids of the polyester component to 10% by solids of the epoxy novolac to 10% by solids of the bis-epi epoxy to 1.2 parts by weight of the isocyanate in an open container without agitation. The composition is then agitated well for 1-5 minutes. The container is then capped with an air-tight lid for 30 minutes to allow for the onset of isocyanate/polyester reaction; or
Procedure 2). The polyester and isocyanate are combined, thoroughly mixed, then allowed to stand at room temperature for a minimum of 30 minutes prior to the epoxy additions to allow onset of the isocyanate/hydroxyl reaction.

The adhesive coating composition resulting from either of the foregoing procedures is then applied by means of the reverse roll coating technique to a 0.025mm (1 mil) polyimide film to yield a 0.025mm (1 mil) thick dry coat weight. Drying (i.e., removal of the solvents) is accomplished through a 22.9m (75 foot)-3 zone oven at 100°C (212°F) and 7.6m (25 feet) per minute. The coated substrate is then positioned next to the treated side of 78.3g (1 oz). copper foil, wherein the copper foil surface is treated with Oak CMC-111 compound (to enhance bondability). The polyimide film and copper foil are heated to 148.9°C (300°F) to 162.7°C (325°F) with an applied pressure of 551.6kPa (80psi) (pounds/square inch) to 827.4kPa (120 psi) through a coater/laminator combining station as part of a continuous operation. The resulting composite is rolled onto a 6" core, left at room temperature for one to seven days then post cured as follows:
2 hours @ 65.5°C (150°F)
2 hours @ 135°C (275°F)
2 hours @ 176.7°C (350°F)
The resulting composite structure exhibited the properties shown in Table I when tested per ANSI/IPC-FC-232B and 241 B procedures:

**TABLE I**

| | |
|---|---|
| Initial Peel | 357.1Kg/m (20PLI) |
| Peel After Solder | 375 Kg/m (21PLI) |

| Chemical Resistance | |
|---|---|
| MEK | 375 Kg/m (21PLI) |
| TOL | 375.1Kg/m (20PLI) |
| IPA | 375 Kg/m (21PLI) |
| T111/MC | 375 Kg/m (21PLI) |
| Solder Float | Pass |
| Aging (96 hrs @ 135°C (275°F) in air circulating oven) | No Bond Strength Change |
| where; PLI = Pounds per lineal inch MEK = Methylethyl ketone TOL = Toluene IPA = Isopropylalcohol T111 = Trichloroethylene MC = Methylene Chloride | |

The polyester compound is a high molecular weight hydroxyl terminated polymer, while the curative compound is a polymeric isocyanate. In the preferred embodiment, a combination of a flexible bis-epi epoxy compound and a hard novolac epoxy compound are both included to achieve the properties of both compounds. The second reaction provides a fully cross-linked network between the 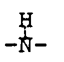
groups formed in the first reaction and the 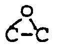
in the epoxy components without evolution of by-products.

The present invention provides what is believed to be the first adhesive system with extremely balanced properties and the added benefit of superior Z-axis stability. More specifically, the present invention provides an epoxy based laminating adhesive which can be continuously processed and cured without the evolution of by-products to provide a flexible bond-ply with the added property of excellent Z-axis stability. The adhesive material is applicable to film substrates (e.g., polyimide), foil substrates (e.g., copper) and hardboard substrates (e.g., FR4 (fiberglass impregnated) hardboard).

The foregoing description is included to illustrate the operation of the preferred embodiment.

## Claims

1. A two-stage process for providing an adhesive material which comprises:
a) reacting an isocyanate component at a temperature of from room temperature up to 121.1°C (250°F) with at least one hydroxy terminated polyester compound of high molecular weight; and
b) reacting the -NH- groups in the isocyanate/polyester component resulting from said isocyanate/polyester reacting step at a temperature of from 121.1°C (250°F) to 204.4°C (400°F) with at least one epoxy component from the groups of bis epi and novolac epoxy components to form a cross-linked product.

2. The process for providing an adhesive material of claim 1 further comprising:
mixing said isocyanate/polyester component with said epoxy compound and applying a resulting mixture to a location requiring said adhesive material prior to reaction between said isocyanate/polyester component and said at least one epoxy component.

3. The process for providing an adhesive material of claim 1 or 2, further comprising:
using 50% - 90% by weight of the said polyester compound and 10 - 50% by weight of said at least one epoxy compound.

4. The process for providing an adhesive material of any of claims 1 to 3 wherein said isocyanate component, said polyester component and said epoxy component are mixed together prior to reacting the components.

5. The process for providing an adhesive material of any of claim 1 to 4 wherein reacting said isocyanate/polyester component with said at least one epoxy component includes reacting 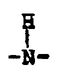 group in the formed urethane linkage with the expoxide 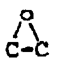 groups of the epoxy components.

6. The use of an adhesive prepared by the process for providing an adhesive material of any of claims 1 to 5 to bond substrates selected from film substrates, foil substrates and hardboard substrates.

## Patentansprüche

1. Zweistufiges Verfahren zur Herstellung eines Klebstoffes, umfassend die folgenden Schritte:
(a) Reagieren einer Isocyanat-Komponente mit einer Polyesterverbindung von hoher Molekülmasse und mit wenigstens einer endständigen Hydroxylgruppe bei einer Temperatur zwischen Zimmertemperatur und 121,1°C (250°F);
(b) Reagieren der -NH-Gruppen in der aus der genannten Isocyanat-Polyester-Reaktion hervorgehenden Isocyanat-/Polyesterkomponente mit wenigstens einer Epoxyharzkomponente aus der Gruppe der Bis-epi- und Novolac-Epoxyharz-Komponenten bei einer Temperatur zwischen 121,1°C (250°F) und 204,4° (400°F) zur Bildung eines vernetzten Produktes.

2. Verfahren zur Herstellung eines Klebstoffes nach Anspruch 1, weiterhin umfassend den folgenden Schritt:
Mischen der genannten Isocyanat-/Polyesterkomponente mit der genannten Epoxyharzverbindung und Auftragen des daraus hervorgehenden Gemischs auf eine Stelle, die des genannten Klebstoffes bedarf, bevor die Reaktion zwischen der genannten Isocyanat-/Polyesterkomponente und der wenigstens einen genannten Epoxyharzkomponente stattfindet.

3. Verfahren zur Herstellung eines Klebstoffes nach Anspruch 1 oder 2, weiterhin umfassend den folgenden Schritt:
Verwenden von 50 - 90 Gew.-% der genannten Polyesterverbindung und 10 - 50 Gew.-% der wenigstens einen genannten Epoxyharzverbindung.

4. Verfahren zur Herstellung eines Klebstoffes nach einem der Ansprüche 1 bis 3, wobei die genannte Isocyanatkomponente, die genannte Polyesterkomponente und die genannte Epoxyharzkomponente vor dem Reagieren der Komponenten vermischt werden.

5. Verfahren zur Herstellung eines Klebstoffes nach einem der Ansprüche 1 bis 4, wobei die Reaktion der genannten Isocyanat-/Polyesterkomponente mit der wenigstens einen genannten Epoxyharzkomponente das Reagieren der 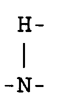 Gruppe in der gebildeten Urethanverbindung mit den Epoxyharz- 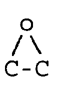 -Gruppen der Epoxyharzkomponenten umfaßt.

6. Verwenden eines mit dem Verfahren zur Herstellung eines Klebstoffes nach einem der Ansprüche 1 bis 5 zubereiteten Klebstoffes zum Verbinden von Substraten wie Filmsubstrate, Foliensubstrate und Hartfaserplattensubstrate.

## Revendications

1. Procédure de fourniture d'une matière adhésive en deux étapes qui comprend:
a) la réaction d'un composant d'isocyanate à une température allant de la température ambiante jusqu'à 121,1°C (250°F) avec au moins un composé de polyester à terminaison hydroxy d'un poids moléculaire élevé; et
b) la réaction des groupes -NH- dans le composant d'isocyanate/polyester résultant de ladite étape de réaction d'isocyanate/polyester à une température allant de 121,1°C (250°F) à 204,4°C (400°F) avec au moins un composant époxyde provenant des groupes de composants époxydes bis epi et novolaque pour former un produit réticulé.

2. Procédure de fourniture d'une matière adhésive selon la revendication 1, comprenant en outre:
le mélange dudit composant d'isocyanate/polyester avec ledit composé époxyde et l'application d'un mélange résultant à un emplacement nécessitant ladite matière adhésive avant la réaction entre ledit composant d'isocyanate/polyester et ledit au moins un composant époxyde.

3. Procédure de fourniture d'une matière adhésive selon la revendication 1 ou 2, comprenant en outre:
l'utilisation de 50% à 90% en poids dudit composé de polyester et de 10 à 50% en poids dudit au moins un composé époxyde.

4. Procédure de fourniture d'une matière adhésive selon l'une quelconque des revendications 1 à 3, dans laquelle ledit composant d'isocyanate, ledit composant de polyester, et ledit composant époxyde sont mélangés ensemble avant la réaction des composants.

5. Procédure de fourniture d'une matière adhésive selon l'une quelconque des revendications 1 à 4, dans laquelle la réaction dudit composant d'isocyanate/polyester avec ledit au moins un composant époxyde comporte la réaction du groupe 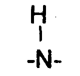 dans la liaison d'uréthane formée avec les groupes époxydes 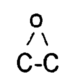 des composants époxydes.

6. Utilisation d'un adhésif préparé par la procédure de fourniture d'une matière adhésive selon l'une quelconque des revendications 1 à 5, pour coller des substrats sélectionnés dans des substrats pelliculaires, des substrats en feuille métallique et des substrats en panneau dur.
